# EUROPEAN PATENT APPLICATION

(11) **EP 2 852 256 A1**
(43) Date of publication of application: **25.03.2015**
(21) Application number: 12879516.8
(22) Date of filing: 20.06.2012
(51) Int. Cl.: H05B 33/22, H01L 51/50, H05B 33/12, H05B 33/26

(54) **ORGANIC ELECTROLUMINESCENCE DEVICE**

(71) Applicant: Pioneer Corporation, Kawasaki-shi, Kanagawa 212-0031 (JP)
(72) Inventor: KURODA, Kazuo, Yokohama-shi Kanagawa 235-0007 (JP); KUDO, Hideo, Kawasaki-shi Kanagawa 212-0031 (JP); OHATA, Hiroshi, Tsurugashima-shi Saitama 350-2203 (JP); UCHIDA, Toshiharu, Kawasaki-shi Kanagawa 212-0031 (JP); TANAKA, Yohei, Kawasaki-shi Kanagawa 212-0031 (JP)
(74) Representative: Manitz, Finsterwald & Partner GbR
(86) International application number: PCT/JP2012/065749
(87) International publication number: WO 2013/190661

(57) **Abstract**

An organic EL device includes at least one insulating bank disposed on a translucent substrate, a translucent electrode in contact with the bank, an organic layer containing a light-emitting layer and formed on the translucent electrode, and a reflection electrode formed on the organic layer. The bank is made from a translucent dielectric material having a low refractive index that is equal to or less than that of the organic layer. The bank has a side face that is a slope inclined with respect to the translucent substrate. The side face has a concave surface shape that faces the light-emitting layer from a slope in contact with the light-emitting layer to a slope in contact with a portion of the organic layer in the vicinity of the reflection electrode.

## Description

### TECHNICAL FIELD

The present invention relates to an organic electroluminescent device (hereinafter referred to as organic EL device) containing at least one organic electroluminescent element.

### BACKGROUND ART

An organic electroluminescent element is a light-emitting element that is configured by layering an anode, an organic layer containing a light-emitting layer, and a cathode in this order on a transparent glass substrate, and expresses electroluminescence (hereinafter referred to as EL) by injection of current in the organic layer through the anode and the cathode. When the electrode on a side of the substrate is made transparent, light emitted from the light-emitting layer is extracted through the transparent electrode and the substrate. However, part of light emitted from the light-emitting layer is trapped by total reflection on a transparent electrode-glass interface and a glass-air interface, and extinguished. Therefore, only about 20% of light emitted from the light-emitting layer can be extracted outside.

Patent Document 1 discloses a technique of improving a light extraction efficiency by making a bank (partition) for partitioning organic layers on a transparent substrate on a light extraction side from a transparent material, and providing a reflection portion for extracting light propagated in the translucent bank to a side of the transparent substrate in a visible direction.

### CITATION LIST

### PATENT DOCUMENTS

Patent Document 1: Japanese Patent Application Laid-Open No. 2005-310591

### SUMMARY OF THE INVENTION

### PROBLEM TO BE SOLVED BY THE INVENTION

In the technique of Patent Document 1, light in a light-emitting layer in contact with a side face of the translucent bank is extracted to the bank. However, there is a problem in which light propagated in the organic layer is attenuated before extraction of light to the bank.

As an example, an object of the present invention is to provide an organic EL device capable of enhancing the light extraction efficiency of light propagated in a transparent electrode.

### MEANS TO SOLVE THE PROBLEM

An organic EL device of the present invention is an organic EL device having a translucent substrate and at least one organic EL element supported on the translucent substrate, wherein
the organic EL element includes at least one insulating bank disposed on the translucent substrate, a translucent electrode in contact with the bank, an organic layer containing a light-emitting layer and formed on the translucent electrode, and a reflection electrode formed on the organic layer,
the bank is made from a translucent dielectric material having a low refractive index that is equal to or less than that of the organic layer, and
the bank has a side face that is a slope inclined with respect to the translucent substrate, and the side face has a concave surface shape that faces the light-emitting layer from a slope in contact with the light-emitting layer to a slope in contact with a portion of the organic layer that is in contact with the reflection electrode.

### BRIEF DESCRIPTION OF DRAWINGS

FIG. 1 is a top plan view of an organic EL device according to an embodiment of the present invention.
FIG. 2 is a cross-sectional view taken along line C-C in FIG. 1.
FIG. 3 is a schematic cross-sectional view illustrating a layered structure of a light-emitting portion of the organic EL device shown in FIG. 1.
FIG. 4 is an enlarged partial cross-sectional view illustrating part of the organic EL device shown in FIG. 1.
FIG. 5 is an enlarged partial cross-sectional view illustrating part of an organic EL device according to another embodiment of the present invention.
FIG. 6 is an enlarged partial cross-sectional view illustrating part of an organic EL device as a modification.
FIG. 7 is an enlarged partial cross-sectional view illustrating part of an organic EL device as another modification.
FIG. 8 is an enlarged partial cross-sectional view illustrating part of an organic EL device as yet another modification.
FIG. 9 is an enlarged partial cross-sectional view illustrating part of an organic EL device as further another modification.
FIG. 10 is an enlarged partial cross-sectional view illustrating part of an organic EL device as yet further another modification.

### DESCRIPTION OF EMBODIMENTS

Hereinafter, embodiments of the present invention will be described with reference to the drawings.

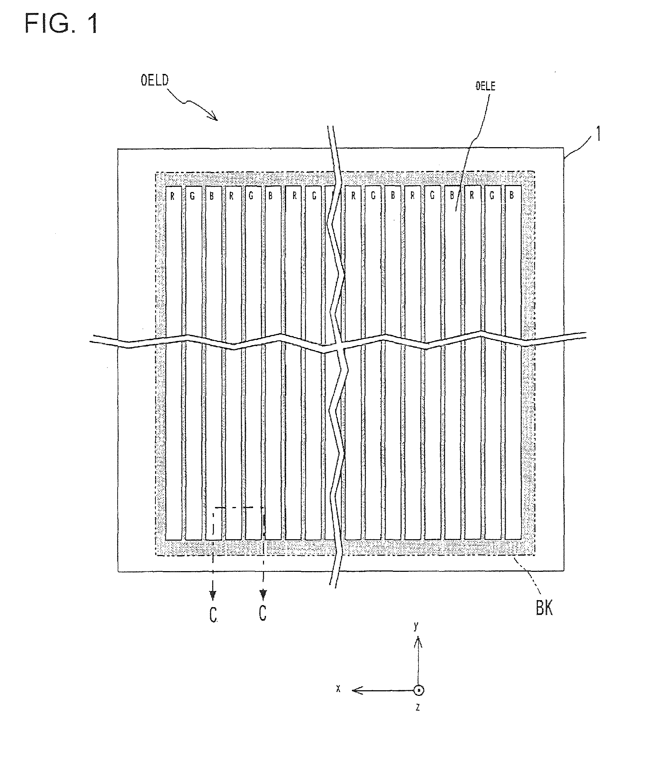

In FIG. 1, an organic EL device OELD includes a plurality of strip-shaped organic EL elements OELEs that are divided by a plurality of banks BK on a light-transmissive plate made of glass or resin as a substrate 1 and extend in a y direction. The organic EL elements OELEs are each aligned, and develop different luminescent colors such as red R, green G, and blue B. Sets of organic EL elements with RGB luminescent colors are each aligned in an x direction.

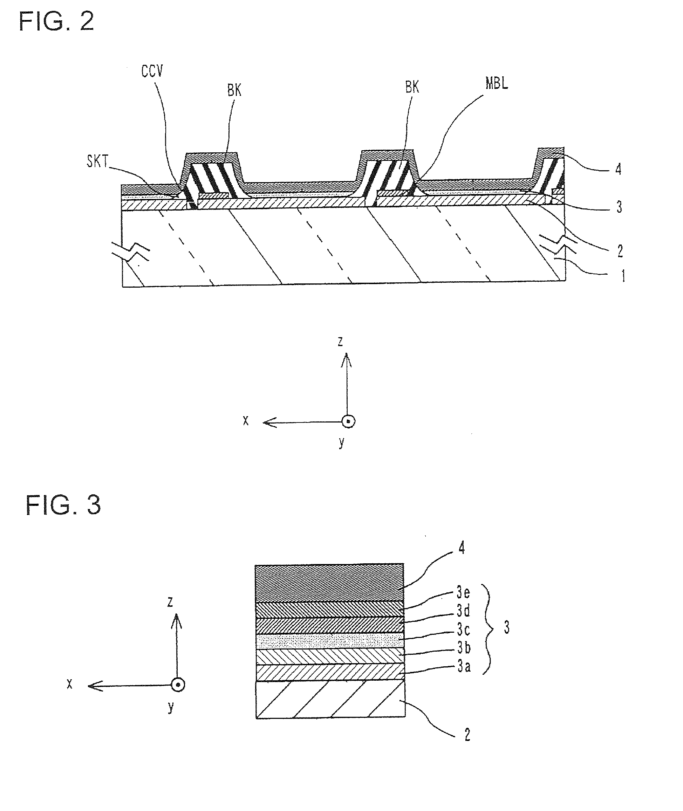

As shown in FIG. 2, each of the organic EL elements in the organic EL device is configured so that a translucent electrode 2, an organic layer 3 containing a light-emitting layer, and a reflection electrode 4 are layered on the substrate 1 between the banks BKs. In the organic EL device, light generated in the organic layer 3 by application of voltage to the translucent electrode 2 and the reflection electrode 4 is extracted from a surface of the substrate 1. The organic EL device is a so-called bottom emission type organic EL panel. Each bank BK in contact with the translucent electrode 2 is made from a light-transmissive dielectric material having a low refractive index that is equal to or less than that of the organic layer 3. Herein, "equal to refractive index" means that a difference between one refractive index and another refractive index is less than 0.3, preferably 0.2 or less, and particularly preferably 0.1 or less. A "low" or "high" degree of a refractive index may be "low" or "high" enough to generate a difference in measurement, and is shown when in practice, the difference is more than 0.1, preferably more than 0.2, more preferably 0.3 or more, further preferably 0.4 or more, and particularly preferably 0.5 or more.

A plurality of translucent electrodes 2 constituting an anode each have a belt shape, extend along the y direction on the substrate 1, and are aligned in parallel to the x direction at certain intervals from one another, and vapor-deposited.

The banks BKs are formed on the substrate 1 and end edges of the translucent electrodes 2 so as to cover them and extend along the y direction. In the banks BKs, each rectangular opening that extends in the y direction is formed. On each opening, the organic layer 3 is disposed. The organic layers 3 are aligned so as to be divided from one another by the banks BKs, and partition a plurality of light-emitting regions divided by the banks BKs. The banks BKs are each covered with at least part of the reflection electrode 4. The banks BKs include an organic material bank and an inorganic material bank. The inorganic material bank is generally formed by a procedure such as etching. As a procedure for forming the organic material bank, a wet coating method such as screen printing, a spraying method, an inkjet method, a spin coating method, gravure printing, and a roll coater method is known.

As shown in FIG. 2, each of the banks BKs in the organic EL device has a side face that is a slope inclined with respect to the translucent substrate 2 along the y direction, and the side face has a concave surface shape CCV that is in contact with the organic layer 3. A skirt portion SKT that is a part of the concave surface shape CCV terminates at an interface between the organic layer 3 and the translucent electrode 2.

As shown in FIG. 3, on the translucent electrode 2 in each opening of the banks BKs, a hole injection layer 3a, a hole transport layer 3b, a light-emitting layer 3c, an electron transport layer 3d, and an electron injection layer 3e in this order are layered as the organic layer 3. The organic layer 3 held between the translucent electrode 2 and the reflection electrode 4 is a light-emitting layered body, is not limited to this layered structure, and for example, may have a layered structure that includes at least a light-emitting layer by adding a hole blocking layer (not shown) between the light-emitting layer 3c and the electron transport layer 3d, or includes a charge transport layer usable as layers. The organic layer 3 may be configured so that the layered structure does not include a hole transport layer 3b, a hole injection layer 3a, or a hole injection layer 3a and an electron transport layer 3d.

For example, as a light-emitting material for the light-emitting layer 3c, any known light-emitting material such as a fluorescent material and a phosphorescent material can be used.

Examples of a fluorescent material giving blue luminescence may include naphthalene, perylene, and pyrene. Examples of a fluorescent material giving green luminescence may include a quinacridone derivative, a coumarin derivative, and an aluminum complex such as tris(8-hydroxy-quinoline)aluminum (Alq₃). Examples of a fluorescent material giving yellow luminescence may include a rubrene derivative. Examples of a fluorescent material giving red luminescence may include a 4-(dicyanomethylene)-2-methyl-6-(p-dimethylaminostyryl)-4H-pyran (DCM)-based compound, a benzopyran derivate, and a rhodamine derivative. Examples of the phosphorescent material may include complex compounds of iridium, platinum, ruthenium, rhodium, and palladium. Specific examples of the phosphorescent material may include tris(2-phenylpyridine)iridium (i.e., Ir(ppy)₃) and tris (2-phenylpyridine)ruthenium.

The organic layers 3 emitting light with respective luminescent colors of red, green, and blue are repetitively disposed in parallel, and light that is recognized as a single luminescent color by mixing red, green, and blue lights at a given ratio is emitted from the surface of the substrate 1 serving as a light extraction surface.

As a procedure for forming the organic layer 3, a dry coating method such as a sputtering method and a vacuum deposition method and a wet coating method such as screen printing, a spraying method, an inkjet method, a spin coating method, gravure printing, and a roll coater method are known. For example, a hole injection layer, a hole transport layer, and a light-emitting layer may be formed by the wet coating method so that each film thickness is uniform, and an electron transport layer and an electron injection layer may be each formed in turn by the dry coating method so that each film thickness is uniform. Further, all functional layers may be formed in turn by the wet coating method so that each film thickness is uniform.

The translucent electrode 2 as an anode that supplies a hole to the functional layers up to the light-emitting layer 3c may be made from indium-tin-oxide (ITO), ZnO, ZnO-Al₂O₃ (i.e., AZO), In₂O₃-ZnO (i.e., IZO), SnO₂-Sb₂O₃ (i.e., ATO), or RuO₂. It is preferable that a material having a transmittance of at least 10% or more in the wavelength of light emitted from the light-emitting layer be selected for the translucent electrode 2.

The translucent electrode 2 usually has a single-layer structure, but if desired, can have a layered structure composed of a plurality of materials.

For the reflection electrode 4 as a cathode that supplies an electron to the functional layers up to the light-emitting layer 3c, for example, a metal such as aluminum, silver, copper, nickel, chromium, gold, or platinum is used, but the material is not limited to these. One kind of the material may be used alone, or two or more kinds thereof may be used in combination at any ratio.

In order to efficiently inject an electron, it is preferable that the material for the reflection electrode 4 include a metal having a low work function. For example, an appropriate metal such as tin, magnesium, indium, calcium, aluminum, or silver, or an alloy thereof is used. Specific examples thereof may include an electrode made of an alloy having a low work function, such as a magnesium-silver alloy, a magnesium-indium alloy, and an aluminum-lithium alloy. A silver thin film with a thickness of 20 nm as the reflection electrode 4 has a transmittance of 50%. An aluminum film with a thickness of 10 nm as the metal thin film has a transmittance of 50%. A magnesium-silver alloy film with a thickness of 20 nm as the metal thin film has a transmittance of 50%. When the reflection electrode 4 is made of a metal thin film, the lower limit of the film thickness needs to be 5 nm to secure conductivity

The reflection electrode 4 may be formed as a single-layer film or a multilayer film on the organic layer 3 by the sputtering method or the vacuum deposition method.

In the organic EL device, the organic layer 3 is held between, and in contact with, the translucent electrode 2 and the reflection electrode 4. Therefore, when a driving voltage is applied to the organic layer 3 through the translucent electrode 2 and the reflection electrode 4, part of light generated in the light-emitting layer 3c in the organic layer 3 passes through the translucent electrode 2, and part of light reflects on the reflection electrode 4 and passes through the translucent electrode 2, and then they are extracted from the surface of the translucent substrate 1.

### [Performance of Organic EL Device]

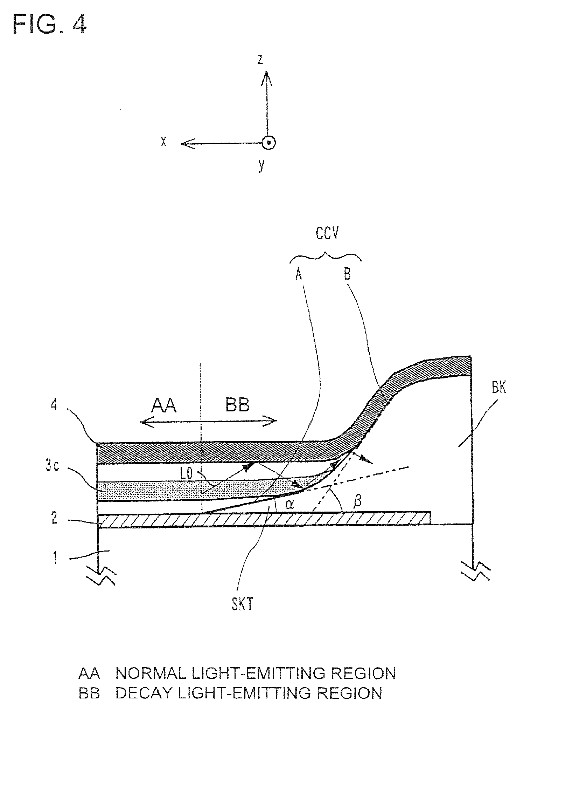

Next, the performance of the organic EL device will be described. Components represented by the same reference signs as in the above-described embodiment are the same as in the organic EL device of the embodiment, and therefore the detailed description thereof will be omitted. In the organic EL devices shown in FIGs. 4 and the following drawings, a description will be given while the refractive index n1 of the glass substrate 1 is 1.5, the refractive index n2 of the translucent electrode 2 is 1.8, the refractive index n2 of the organic layer 3 is 1.8, and the refractive index n1 of the bank BK is 1.5.

As shown in FIG. 4, the bank BK in the organic EL device has a side face that is a slope inclined with respect to the translucent substrate 2. The side face of the bank BK has a concave surface shape CCV that faces the light-emitting layer 3c from a slope A in contact with the light-emitting layer 3c to a slope B in contact with a portion of the organic layer 3 that is in contact with the reflection electrode 4.

The side face of the bank BK includes a skirt portion SKT in which an angle α between the slope A in contact with the light-emitting layer 3c and the translucent substrate 2 is smaller than an angle β between the slope B in contact with the portion of the organic layer 3 that is in contact with the reflection electrode 4 and the translucent substrate 2. Specifically, the inclination angle α of the bank BK with respect to an interface between the light-emitting layer 3c and the translucent electrode 2 and the inclination angle β of the bank BK with respect to a face of the reflection electrode 4 are different, and have a relation of α < β. The skirt portion SKT of the bank BK terminates at an interface between the organic layer 3 and the translucent electrode 2. The organic layer 3 is separated by the termination of the bank BK, the organic layer 3 on a side of the bank BK is a decay light-emitting region, and the organic layer 3 away from the skirt portion SKT of the bank BK is a normal light-emitting region. This is because the translucent electrode 2 is covered with the skirt portion SKT, and the translucent electrode 2 as the anode and the reflection electrode 4 as the cathode are not opposite to each other through the organic layer 3.

Light L0 that enters a taper portion of the organic layer 3 at an end edge on the bank BK side, that is, the decay light-emitting region, repetitively reflects zigzag between the tapered reflection electrode 4 and the side face (i.e., skirt portion SKT) of the bank BK, and finally enters the outermost edge of the organic layer 3. As a result, reflective light extremely decreases and enters only the side face of the bank BK. Therefore, the embodiment has a mechanism in which reflection is repeated at the taper portion of the organic layer 3 at the end edge with a wedge-shaped cross section to introduce light L0 inward into an upper portion of the bank BK and the light L0 is emitted toward only the side face of the bank BK. When light in the organic layer 3 with a high refractive index enters the bank BK made from a low-refractive index material, light with an angle that is equal to or more than a critical angle totally reflects on an interface that is plane and does not enter the side of the bank BK with a low refractive index. This is because the organic layer 3 has a high-refractive index region (n2 = 1.8). However, most light in the upper portion of the bank BK becomes light with an angle that is less than the critical angle, and is extracted to the bank BK side.

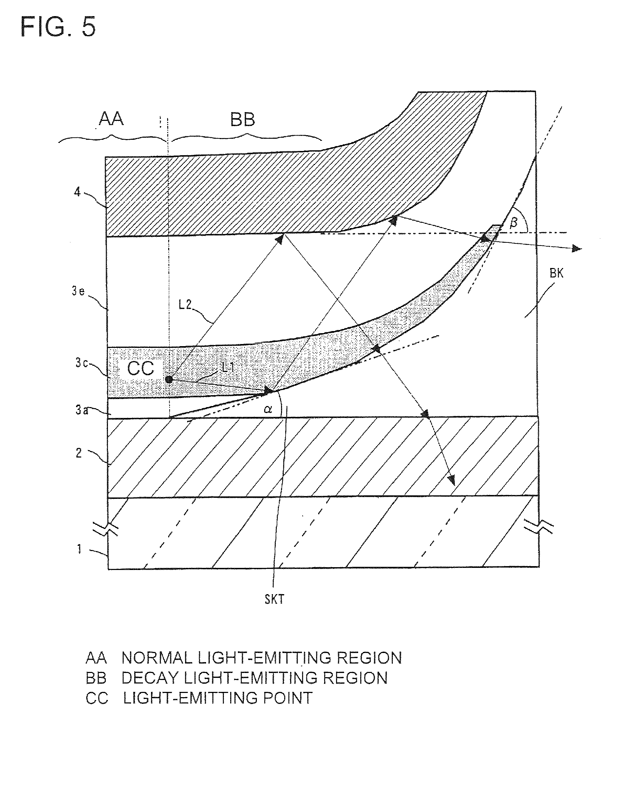

FIG. 5 shows part of an organic EL element in an organic EL device in which an ITO translucent electrode 2 as an anode, a hole injection layer 3a, a light-emitting layer 3c, an electron injection layer 3e, and a reflection metal electrode 4 as a cathode are layered on a transparent glass substrate 1. An organic layer up to the light-emitting layer 3 is formed by the wet coating method such as an inkjet method, and the organic layer of the electron injection layer 3e and the following layers is formed by a vapor deposition method.

In FIG. 5, an organic layer 3 on a side of a bank BK that has a concave surface shape CCV between slopes A and B of the bank BK can be considered as part of a cylinder lens that extends in a y direction as a depth direction. In the organic EL device, the inclination angle α of the bank BK with respect to an interface of the light-emitting layer 3c (inclination angle of the bank BK with respect to a face that passes through a light-emitting point in a normal light-emitting region and is parallel to the translucent electrode 2) is smaller than the inclination angle β of the bank BK in contact with the reflection electrode 4.

In a side from the light-emitting point away from the bank BK, the translucent electrode 2 as the anode and the reflection electrode 4 as the cathode are normally opposite to each other. In an area from the light-emitting point away from the bank BK, luminescence is normal, and in an area closer to the bank BK, the luminescent amount decreases.

The thickness of the slope A portion with an inclination angle α of a skirt portion SKT gradually increases from the translucent electrode 2 substantially at the inclination angle α. The bank BK is made from a light-transmissive dielectric material with a refractive index n1 of 1.5 and the light-emitting layer 3c is made from a light-emitting material with a refractive index n2 of 1.8. Therefore, the refractive indexes n1 and n2 satisfy a relation of n1 > n2, and in an interface between the bank BK and the light-emitting layer 3c, evanescent light is generated below the skirt portion SKT of the bank BK with a low refractive index. Further, when the translucent electrode 2 with a refractive index of 1.8 is present below the skirt portion SKT, light does not totally reflect until the thickness of the skirt portion SKT reaches about 80 nm, and therefore light passes through the substrate 1. The amount of evanescent light to be exuded exponentially decreases, and is considered to be substantially up to a wavelength thereof. However, the substantial range thereof is about 150 nm. Emitted light passes through the skirt portion SKT with a thickness of about 25 nm to 30 nm, and in the skirt portion with a thickness that is equal to or more than the thickness, an angle at which light totally reflects is expressed.

At a portion in which normally emitted light L1 totally reflects, the angle of the slope B is more acute than that of the slope A (α < β). Therefore, as shown in FIG. 5, normally emitted light L1 totally reflects on the slope A, then totally reflects on the slope B, reflects on the reflection electrode, and enters the bank BK at the slope B.

Light L2 that totally reflects on the slope A and directly reflects on the reflection electrode 4 enters the bank BK at the slope B.

As described above, in the embodiment, the inclination of the bank BK varies depending on the position of the organic layer, the inclination angle β is made smaller than the inclination angle α, and the light-emitting layer 3c is disposed inside the concave shape. Therefore, even when a low refractive index material is used, a large amount of light can enter the translucent bank BK. The light extraction efficiency of the concave surface shape CCV is improved, and in addition, incidence of light to the bank BK with a low refractive index increases as compared with just a steep plane slope. This is because near-field light in a thin film portion of the skirt portion SKT is utilized.

Further, an end part of the concave surface shape CCV (skirt portion SKT) is put between the organic layer 3 and the translucent electrode 2. Therefore, even when the translucent dielectric material for the bank is especially not lyophilic, almost no consideration for the wetting properties of the organic material is required. In general, when the tilt of the bank is decreased, the lyophilicity increases, and the organic material is easily applied. Therefore, it is not necessary that a lyophilic material is specially used for the bank BK, and a choice of material for the bank increases. Examples of the material for the bank may include fluorinated resins such as a fluorinated polyolefin-based resin, a fluorinated polyimide resin, and a fluorinated polyacrylic resin.

Since the skirt portion SKT of the concave surface shape CCV is put between the organic layer 3 and the translucent electrode 2, leak and short circuit between the translucent electrode 2 and the reflection electrode 4 can be prevented.

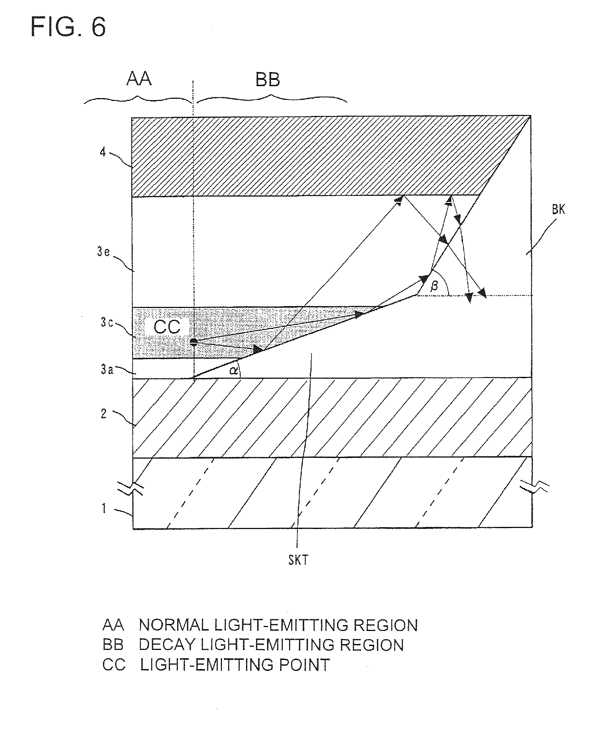

The translucent bank BK shown in FIG. 5 has a concave surface shape CCV in which the title gradually varies, but is not limited to this shape. As shown in FIG. 6, a translucent bank BK may be configured so that slopes A and B are plane and have inclination angles α and β, respectively.

### [Modifications]

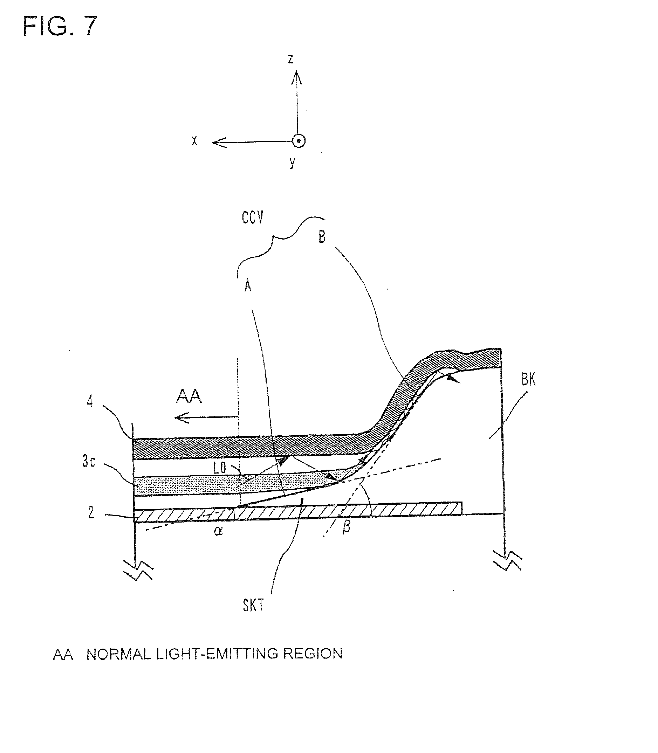

FIG. 7 is a cross-sectional view illustrating a periphery of the bank BK that is partially cut away from the organic EL device according to a modification. In the following examples, components represented by the same reference signs as in the above-described embodiment are the same as in the organic EL device of the embodiment, and therefore the detailed description thereof will be omitted.

In the modification of FIG. 7, the organic layer up to the light-emitting layer 3c is formed by a wet coating method such as an inkjet method, and the organic layer of the electron transport layer and the following layers is formed by a vapor deposition method using a mask. The organic layer 3 including the electron transport layer and the electron injection layer is formed to the vicinity of a top of the bank BK using a mask with a widened opening during vapor deposition of the electron transport layer and the electron injection layer. As a result, a portion where the organic layer is not formed on the top side of the bank BK by vapor deposition, that is, a portion where the reflection electrode 4 is in contact with the bank BK is formed. According to the modification of FIG. 7, when total reflection of light is repeated until light reaches the slope of the bank that is in contact with a portion of the organic layer 3 that comes into contact with the reflection electrode 4 of the top side, light reaches the reflection electrode 4 of the top side. The light can then enter the translucent bank BK.

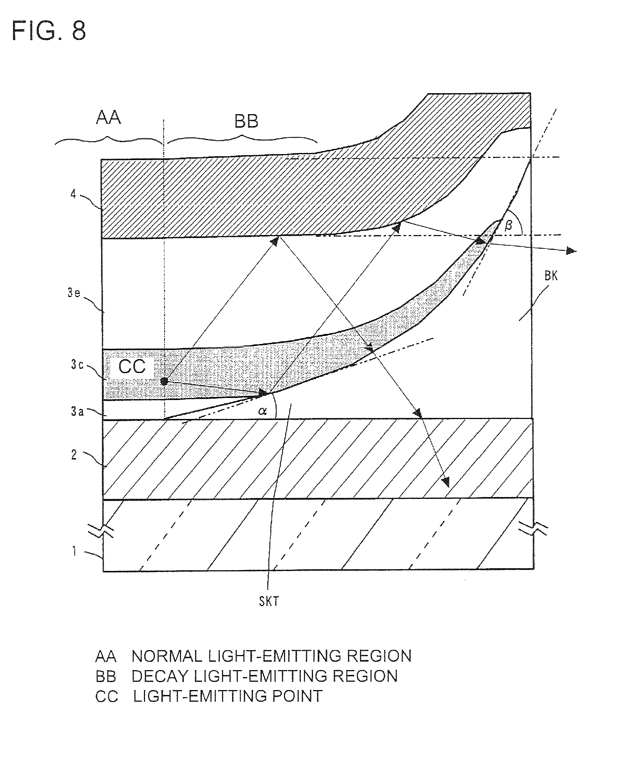

In a modification shown in FIG. 8, all layers in the organic layer 3 are coating-type layers formed by a wet coating method such as an inkjet method. An end part of the electron injection layer 3e formed by the wet coating method terminates at the side face of the bank BK.

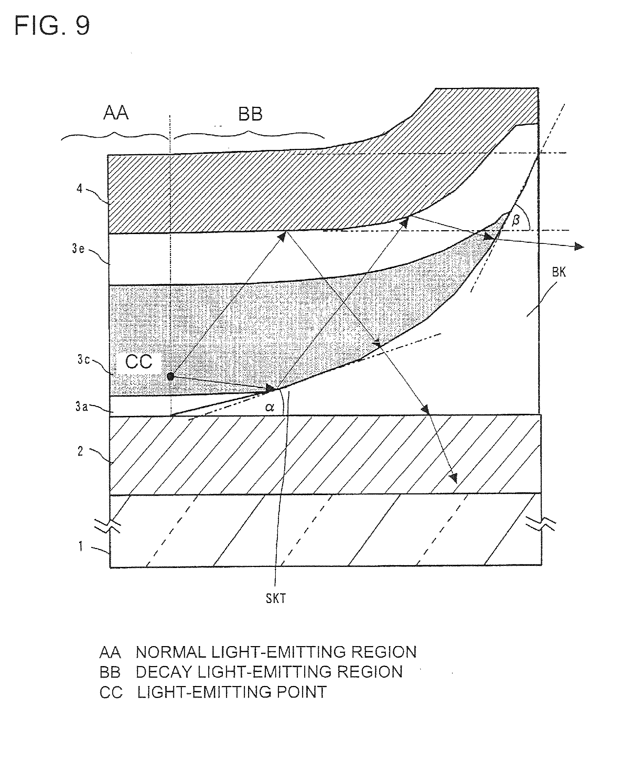

In a modification shown in FIG. 9, all layers in the organic layer 3 are coating-type layers formed by a wet coating method, the thickness of the light-emitting layer 3c is increased, and the thickness of the electron injection layer 3e is decreased.

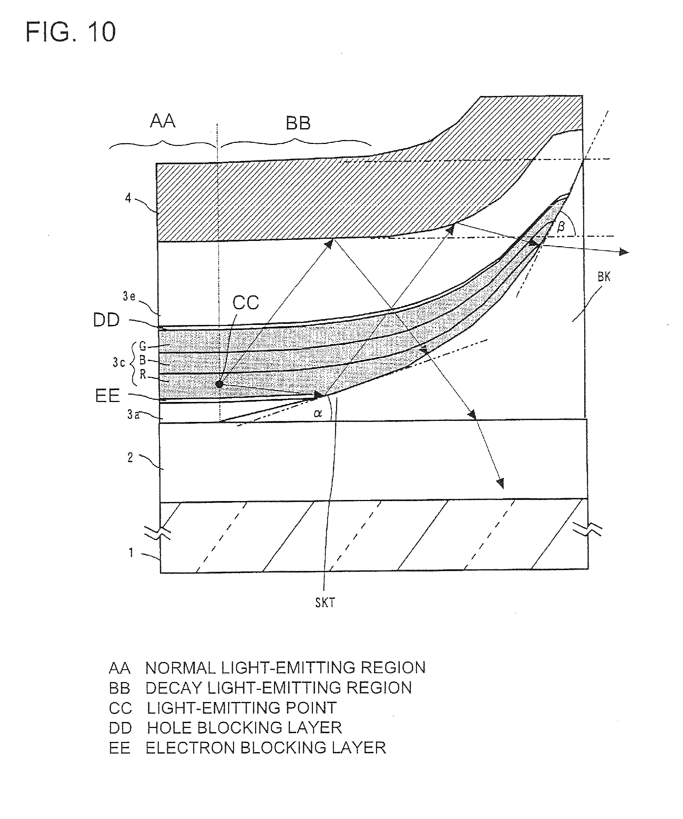

In a modification shown in FIG. 10, all layers in the organic layer 3 are coating-type layers formed by a wet coating method, and an electron blocking layer, RGB light-emitting layers as a light-emitting layer 3c, and a hole blocking layer are layered from the hole injection layer 3a side to the electron injection layer 3e side.

In all the embodiments, when a translucent low-refractive index material is used at a non-light-emitting area such as the bank BK in the organic EL device, light that totally reflects on the translucent electrode 2 portion in the organic layer 3 enters a side face portion of the bank BK. The refraction angle thereof varies, and the light is emitted toward the substrate 1 at various radiation angles. Thus, the light extraction efficiency of light propagated in the transparent electrode can be enhanced.

As the translucent substrate 1, a plate of quartz glass or glass, a metal plate, a metal foil, a flexible resin substrate, a plastic film or sheet, or the like, can be used. In particular, a glass plate, and a transparent plate of synthetic resin such as polyester, polymethacrylate, polycarbonate, and polysulfone are preferred. When using a synthetic resin substrate, gas barrier properties should be noted. When the gas barrier properties of the substrate are too small, the organic EL device may deteriorate due to air that passes through the substrate. Therefore, it is not preferable. Accordingly, one of preferable methods is a method in which a compact silicon oxide film or the like is provided on at least one side of the synthetic resin substrate to ensure the gas barrier properties.

Further, a sealing can (not shown) may be provided to cover a light-emitting portion aligned in a belt shape on the organic EL device and a bank around the portion and seal them. In order to enhance the light extraction efficiency of emitted light, a light extraction film (not shown) may be attached to an outer surface of the substrate 1 so as to cover a light-emitting portion and have an area larger than that of the light-emitting portion.

In all the embodiments, the organic layer is a light-emitting layered body, but the light-emitting layered body may be configured by layering inorganic material films.

### REFERENCE SIGNS LIST

- 1: substrate
- 2: translucent electrode
- 3: organic layer
- 3a: hole injection layer
- 3b: hole transport layer
- 3c: light-emitting layer
- 3d: electron transport layer
- 3e: electron injection layer
- 4: reflection electrode
- BK: bank
- SKT: skirt portion

## Claims

1. An organic EL device comprising a translucent substrate and at least one organic EL element supported on the translucent substrate, wherein
the organic EL element includes at least one insulating bank disposed on the translucent substrate, a translucent electrode in contact with the bank, an organic layer containing a light-emitting layer and formed on the translucent electrode, and a reflection electrode formed on the organic layer,
the bank is made from a translucent dielectric material having a low refractive index that is equal to or less than that of the organic layer, and
the bank has a side face that is a slope inclined with respect to the translucent substrate, and the side face has a concave surface shape that faces the light-emitting layer from a slope in contact with the light-emitting layer to a slope in contact with a portion of the organic layer that is in contact with the reflection electrode.

2. The organic EL device according to claim 1, wherein the side face includes a skirt portion where an angle formed between a slope in contact with the light-emitting layer and the translucent substrate is smaller than an angle formed between the translucent substrate and a slope in contact with a portion of the organic layer that is in contact with the reflection electrode.

3. The organic EL device according to claim 2, wherein the bank terminates at an interface between the organic layer and the translucent electrode.

4. The organic EL device according to any one of claims 1 to 3, wherein the bank is covered with at least part of the reflection electrode.
